# EUROPEAN PATENT APPLICATION

(11) **EP 4 531 268 A1**
(43) Date of publication of application: **02.04.2025**
(21) Application number: 23200015.8
(22) Date of filing: 27.09.2023
(51) Int. Cl.: H02P 9/00

(54) **METHOD AND CONTROL UNIT FOR DETECTING AN ONSET OF POLE SLIP IN AN ELECTRIC GENERATOR DRIVEN BY AN ENGINE**

(71) Applicant: Caterpillar Energy Solutions GmbH, 68167 Mannheim (DE)
(72) Inventor: Aren, Assiet, 68167 Mannheim (DE); Mueller, Paul, 68167 Mannheim (DE)
(74) Representative: Nordmeyer, Philipp Werner

(57) **Abstract**

The present invention refers to a method for protecting a synchronous electric generator (16) from pole slip which is driven by an engine (18) via a coupler and which comprises step of obtaining a stator voltage signal being indicative of a voltage in a stator (28) of the generator (16); a step obtaining an engine speed signal being indicative of an engine speed of the engine (18); and a step of detecting an onset of pole slip based on the stator voltage signal and the engine speed signal.

## Description

### Technical Field

The present invention refers to a method and a control unit for detecting an onset or risk of pole slip, in particular an approaching pole slip, in a synchronous electric generator driven by an engine via a coupler. In a further development, the present invention refers to a method and control unit for protecting a synchronous electric generator driven by an engine via a coupler from pole slip Furthermore, the present invention is directed to a generator set comprising such a control unit.

### Technological Background

A generator is typically part of a generator set and is formed as an electric machine configured to convert mechanical rotation into electrical energy. The electrical energy is generated by electromagnetic interactions caused by windings, also referred to as main windings, on a rotor of the generator and may be used for a variety of applications. One large scale application includes power generation for a power grid, wherein the grid defines a load connected to the generator.

In order to provide sufficient functional stability for such power grid, the operation of the generator or generator set needs to be essentially in synchronization with the actual load of the grid. However, conditions such as low excitation, abrupt load change, or even faults in the circuits may cause the sudden rotor angle changes in the generator. When the rotor angle changes beyond a certain limit, the rotor's pole is to become out of step, a condition also referred to as "pole slip". Such a pole slip may cause damage to generator components and may lead to instability in power generation. Contrary to occasionally occurring power swings or fluctuations, which typically occur only temporarily, instabilities caused by pole slip events may progress and may eventually lead to a malfunctioning of the generator set and a corresponding power outage. Since pole slip events progress rapidly, countermeasures need to be effected early to avert any damages.

Protection mechanisms are known which aim on recognizing or detecting pole slip events, in particular rotor angle changes, so as to counteract any malfunction or damage of the generator. However, known protection methods may require additional generator components, such as sensory equipment, and may be costly and difficult to implement.

Accordingly, there is a need to provide early detection of pole slip events, such as rotor angle changes, which in particular may be easily implemented and adapted to the respective generator and power grid requirements.

### Summary of the invention

Starting from the prior art, it is an objective to provide an improved method for detecting an onset of pole slip in a synchronous electric generator driven by an engine via a coupler, which in particular enables easy and cost-efficient implementation. A further objective is to provide a control unit for carrying out such a method and a generator set comprising such a control unit.

These objectives are solved by means of the subject matter of the independent claims. Preferred embodiments are set forth in the present specification, the Figures as well as the dependent claims.

Accordingly, a method is provided for detecting an onset of pole slip, in particular pole slip changes, in an electric generator driven by an engine via a coupler, in particular a relatively stiff coupler, comprising a step of obtaining a stator voltage signal being indicative of a voltage in a stator of the generator; a step obtaining an engine speed signal being indicative of an engine speed of the engine; and a step of detecting an onset of pole slip, in particular pole slip changes based on the stator voltage signal and the engine speed signal.

Furthermore, a control unit is provided for detecting an onset of pole slip in a synchronous electric generator driven by an engine via a coupler, wherein the control unit is configured for obtaining a stator voltage signal being indicative of a voltage in a stator of the generator; obtaining an engine speed signal being indicative of an engine speed of the engine; and detecting an onset of pole slip based on the stator voltage signal and the engine speed signal.

The control unit, which may also be referred to as a protection unit, may serve and be configured for performing the proposed method. Thus, any technical features disclosed in the present disclosure in connection with the proposed method may also refer and be applied to the suggested control unit, and vice versa.

Furthermore, influence of the relatively stiff coupler is considered to compensate the angle changes via the coupler. The coupler angle change is an add-on to the above mentioned angle when the generator is in both a steady state operation and in dynamic reactions.

Furthermore, a generator set may be provided comprising an electrical generator driven by an internal combustion engine and the above described control unit for detecting an onset of pole slip in the electrical generator.

### Brief description of the drawings

The present disclosure will be more readily appreciated by reference to the following detailed description when being considered in connection with the accompanying drawings in which:
Figure 1 schematically shows a block diagram of a generator set according to an embodiment of the present invention which is electrically connected to power grid; and
Figure 2 shows a flow diagram illustrating a method for detecting an onset of pole slip in an electric generator driven by an internal combustion engine according to an embodiment of the present invention.

### Detailed description of preferred embodiments

In the following, the invention will be explained in more detail with reference to the accompanying Figures. In the Figures, like elements are denoted by identical reference numerals and repeated description thereof may be omitted in order to avoid redundancies.

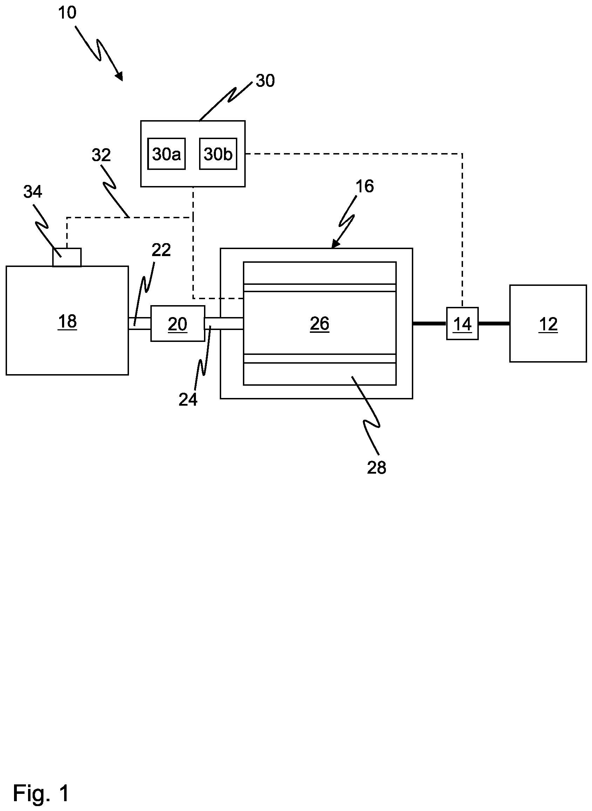

Figure 1 depicts an embodiment of a generator set 10 configured to supply electrical energy to a power grid 12. For doing so, the generator set 10 is electrically connected to the power grid 12 via an electrical connecting device 14, in particular in the form of a network switch. The power grid 12, which may also be referred to as an electrical power supply network, may be a public power supply network which predetermines the network frequency. In this configuration, the generator set 10 may be part of a generator station of the power grid 12.

However, the generator set 10 proposed in the present disclosure is not limited to this application, but instead may be provided for a wide range of different applications and in a wide range of voltage, frequency and power ratings. For example, the proposed generator set may alternatively be used to supply electrical energy to a local power supply network involving isolated island operation, in which particularly the network frequency may be predetermined by the generator set. Alternatively or additionally, the proposed generator set 10 may be used for power supply in places without connection to a power grid. Alternatively or additionally, the proposed generator set 10 may be used for emergency power supply if a power grid fails. Further, the generator set 10 may be stationary or portable, such as a trailer-mounted generator set.

For generating electrical energy, the generator set 10 comprises an electric generator 16, referred to as "the generator" in the following, which is driven by an engine 18, in particular an internal combustion engine, via a coupler 20, in particular a relatively stiff coupler. Preferably, the generator 16 is provided in the form of an alternator. The engine 18 is preferably provided in the form of a reciprocating engine, which may run on at least one of gasoline, diesel, bio-diesel, natural gas, propane, biogas, coal gas, hydrogen, and on any other suitable gaseous or liquid fuel. For example, the engine 18 may be a gas engine, a diesel engine or a dual fuel engine. Accordingly, in dependence of the deployed engine type, the generator set 10 may be a gas generator set, a diesel generator set, etc.

The engine 18 is structurally coupled to the generator 16 via a coupler 20 which forms a structural connection allowing that the generator 16 is actuated by the engine 18. In other words, the engine 18, in particular an output shaft 22 thereof, more particularly a crankshaft thereof, is torque-transmittingly coupled to the generator 16, in particular to an input shaft 24 thereof, more particularly a rotor 26 thereof, via the coupler 20. By this configuration, the engine 18 rotatably actuates the rotor 26 relative to a stator 28 of the generator 16 and, due to electromagnetic interactions between the rotor 26 and its surrounding stator 28, generates electric power which is supplied to the power grid 12.

The generator 16 is a synchronous electric generator which generates an alternating current synchronized to the power grid. Further, the generator 16 may be a three-phase generator which may be equipped with three windings, in particular three different main windings, at its stator 28.

The generator set 10 further comprises a control unit 30 configured to monitor and optionally control operation of the generator set 10. According to one embodiment, the control unit 30 may comprise or be provided in the form of a computer unit. More particularly, the control unit 30 may comprise a central processing unit (CPU) 30a configured to execute digital instructions and provide an output, and a memory 30b for storing digital instructions (e.g., a computer program) and/or output received from CPU 30a, as will be apparent to one skilled in the art in view of the present disclosure.

In order to monitor and optionally control operation of the generator set 10, the control unit 30 is communicatively connected to sensors, measurement units, actuators and/or switches of the generator set 10 as will be specified below. For doing so, at least one data interface 32 is deployed via which the control unit 30 communicates with the different measurement units, actuators and/or switches. In the shown configuration, the data interface 32 is provided in the form of signal lines extending from the control unit 30 to each one of the generator 16, the engine 18, and the electrical connecting device 14. Alternatively, the data interface 32 may be a wireless interface.

The basic structural and functional configuration of such a generator set 10 is well known to a person skilled in the art and is thus not further described in the present disclosure. Rather, a method for detecting an onset of a pole slip in the generator 16 according to the present invention is specified in the following. Although not further described hereinafter, it is apparent to the skilled person that the generator set 10 may comprise further components such as a fuel supply, a constant engine speed regulator, a generator voltage regulator, cooling and exhaust systems, etc.

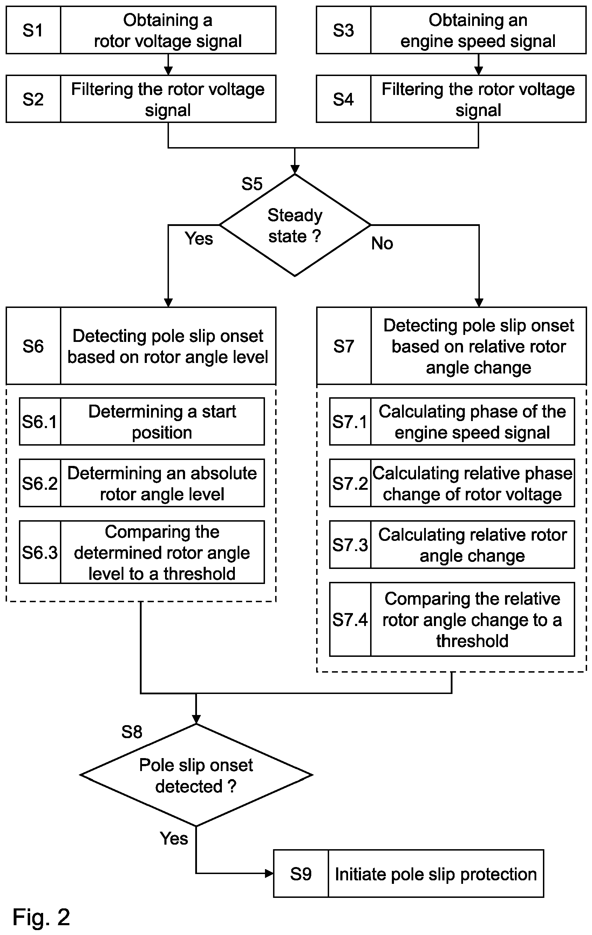

Fig. 2 depicts a flow diagram illustrating an embodiment of the proposed method for detecting an onset of pole slip in the generator 16. In a further development, the method configured or intended for protecting the generator form pole slip. Specifically, the control unit 30 of the generator set 10 depicted in Fig. 1 may be configured to carry out the method according to Fig. 2.

In the context of the present disclosure, the term "onset of pole slip" refers to an operating condition of the generator set 10 which is indicative of an approaching or imminent pole slip in the generator 16. As such, the onset of pole slip preferably refers to a condition of the generator 16 before an actual pole slip event occurs or before a pole slip is in an advanced stage. By doing so, the proposed method enables early detection of pole slip events, thereby allowing to prevent or counteract pole slip and their progression as well as damages which may arise therefrom.

As can be gathered from Fig. 2, in a first step S 1 of the method, a stator voltage signal is obtained which is indicative of a voltage in the stator 28 of the generator 16. Specifically, the stator voltage signal may be indicative of, in particular may represent or quantify, a voltage in or a voltage measurement from the stator 28, in particular in or from at least one winding, specifically in or from at least one main winding of the stator 28. In the shown configuration, the control unit 30, via data interface 32, may receive the stator voltage signal from the generator 16, in particular from the stator 28, more particularly from at least one main winding thereof.

The stator voltage signal may be a raw measurement signal or a processed measurement signal. Further, the voltage measurement signal may be a digital or an analog signal. Still further, the stator voltage signal may be a continuous signal and/or may represent or indicate a continuous voltage value or continuous voltage measurement in the stator 28. In other words, in step S 1, a voltage measurement, in particular a continuous voltage measurement from the stator 28, in particular from at least one of its main windings, is obtained by the control unit 30.

According to one configuration, the control unit 30 may receive the stator voltage signal from a voltage measurement unit. The voltage measurement unit may receive a raw voltage measurement signal measured in the stator 28, in particular in at least one of its main winding, and may process the thus received signal before providing it to the control unit 30. The voltage measurement unit may be provided separately from the control unit 30. For example, the voltage measurement unit may be employed in or may be attached to the generator 16. In this configuration, the stator voltage signal may correspond to or indicate the processed voltage measurement signal. Alternatively, the voltage measurement unit may be a part of or may be included in the control unit 30. Accordingly, in this configuration, the stator voltage signal may correspond to or indicate the raw voltage measurement signal.

In an optional step S2, the stator voltage signal is subjected to a filtering procedure. In other words, the stator voltage signal may be corrected using a filter, in particular a low-pass filter. In this way, high frequency harmonics may be effectively corrected and the signal may be smoothened to improve signal quality.

In a further step S3, an engine speed signal is obtained which is indicative of an engine speed of the engine 18. As can be gathered from Fig. 2, step S3 is performed in parallel to steps S 1 and S2. In the shown configuration, the control unit 30 receives the engine speed signal from the engine 18, in particular from a rotary speed sensor 34 arranged in the engine 18. The rotary speed sensor 34, for example, may be configured to sense tooth flanks of a toothed wheel arranged, for example, around crankshaft to determine a time difference elapsing between sensing neighboring teeth, based on which rotational speed and thus engine speed is determined. Specifically, the rotary speed sensor 34 may be configured to continuously transmit the engine speed signal. Accordingly, the control unit 30 may continuously receive the stator voltage signal and the engine speed signal during operation of the generator set 10.

In an optional step S4, the engine speed signal is subjected to a filtering procedure similar to step S2. Specifically, the engine speed signal may be corrected using a filter, in particular a low-pass filter. In this way, high frequency harmonics may be effectively corrected and the signal may be smoothened.

In a further step S5, an operating mode of the generator set 10, in particular of the coupler 20 is determined. According to the shown method, the way how, i.e. based on which parameters and based on which procedure, onset of pole slip is detected differs among different operating modes of the generator set 10, as will be described below. In other words, detection of onset of pole slip is performed in dependence on the determined operating mode.

Specifically, in step S5, the control unit 30 determines whether or not the generator set 10, in particular the coupler 20, is being operated in a steady state. More specifically, the control unit 30 determines whether the generator set 10, in particular the coupler 20, is being operated in the steady state or a dynamic state.

In the context of the present disclosure, the term "steady state" refers to an operating mode of the generator set 10, in particular of the coupler 20, during which a rotational speed of the rotor 26 and/or the engine 10 remains substantially constant, i.e. a rate of change of the rotational speed of the rotor 26 and/or the engine 10 does not exceed a predetermined threshold. In the steady state, the load on the generator set 10 may be substantially constant or may change smoothly or gradually.

Accordingly, the term "dynamic state" refers to an operating mode in which the generator set 10 is operated outside the steady state, i.e. during which the rotational speed of the rotor 26 and/or the engine 10 does not remain substantially constant, i.e. a rate of change of the rotational speed of the rotor 26 and/or the engine 10 exceeds the predetermined threshold.

Specifically, in step S5, the operating mode may be determined based on at least one of a rate of change of a load of the generator set 10 and a rate of change of a rotational speed of the engine 18 or rotor 26.

For example, for determining whether the generator set 10, in particular the coupler 20, is operated in the steady state or dynamic state, the control unit 30 may determine whether a rate of change of the rotational speed of the rotor 26 and/or the engine 10 exceeds the predetermined threshold. For doing so, the control unit 30 may be configured to determine the rotational speed of the engine 18 and the rate of change of the rotational speed based on the obtained engine speed signal. Alternatively or additionally, the control unit 30 may be configured to determine the rotational speed of the electrical magnetic field from stator 28and the rate of change of its rotational speed based on the obtained stator voltage signal. For doing so, the control unit 30 may detect subsequent zero cross points in the voltage measurement indicated by the stator voltage signal to determine a voltage phase and based thereupon rotational speed of the electrical magnetic field from stator 28. If the rate of change exceeds the predetermined threshold within a given time period, the control unit 30 may determine that the generator set 10 is operated in the dynamic state. Otherwise, the control unit 30 determines that the generator set 10 is operated in the steady state.

Alternatively or additionally, for determining whether the generator set 10, in particular the coupler 20, is operated in the steady state or dynamic state, the control unit 30 may determine whether the generator set 10 is subjected excessive load changes. For doing so, a rate of change of the load on the generator set 10 may be determined and compared to a threshold. For example, a change of rate of an output power of the engine 18 and/or the generator 16 may be determined and compared to a predetermined threshold. Specifically, if the change of rate exceeds the predetermine threshold, the control unit 30 may determine that the generator set 10 is operated in the dynamic state. Otherwise, the control unit 30 determines that the generator set 10 is operated in the steady state.

If, as a result of step S5, it is determined that the generator set 10, in particular the coupler 20, is operated in the steady state, the method proceeds to step S6. Yet, if it is determined in step S5 that the generator set 10, in particular the coupler 20, is not operated in the steady state, i.e. is operated in the dynamic state, the method proceeds to step S7.

In other words, if it is determined that the generator set 10 is being operated in the steady state operating mode, the step S6 of detecting the onset of pole slip is performed. Yet, if it is determined that the generator set 10 is not in the steady state operating mode, the step S7 of detecting the onset of pole slip is performed which differs from step S6.

Step S6 refers to a step of detecting an onset of pole slip based on the stator voltage signal, specifically based on an absolute rotor angle level. Specifically, in a first sub-step S6.1, a start position of the rotor 26 is determined, i.e. an absolute rotor angle in normal or synchronous operating state. Then, in a further sub-step S6.2, an absolute rotor angle level is determined based on the stator voltage signal. Specifically, the absolute angle may be determined based on measured electrical parameters, in particular based on the voltage represented by the stator voltage signal, and a measured current in the stator 28, in particular in at least one of the main windings of the stator 28. Then, in a further sub-step S6.3, the absolute rotor angle level determined in sub-step S6.2 or a difference between the absolute rotor angle level determined in sub-step S6.2 and the starting position determined in sub-step S6.1 is compared to a predetermined rotor angle level threshold to determine the onset of pole slip. Specifically, if the determined absolute rotor angle level or the difference between the determined absolute rotor angle level and the determined starting position exceeds the rotor angle level threshold, an onset of pole slip is detected in step S8 and the method proceeds to step S9.

Step S7 refers to a step of detecting an onset of pole slip based on the stator voltage signal and the engine speed signal, specifically based on a relative rotor angle change which is determined based on the stator voltage signal and the engine speed signal. By doing so, the proposed method enables to compensate dynamic influence of coupler 26.

For doing so, in a first sub-step S7.1, a phase of the engine speed signal is calculated. In this context, the phase of the engine speed signal may refer to a cycle during which the output shaft 22, in particular a crankshaft of the engine 18, performs a full rotation. In other words, a phase of 2π refers to a full rotation of the output shaft 22. Alternatively, the phase of the engine speed signal may refer to a cycle during which the output shaft 22 of the engine 18 performs 1/n of a full rotation or n-times of a full rotation, wherein n is a natural number, i.e. n E N. The parameter n depends on the configuration of the generator 16, in particular of the configuration of the stator 28 and rotor 26, and/or of the coupling between the generator 16 and the engine 18.

In a further sub-step S7.2, a relative phase change of the voltage of the stator 28, in particular of at least one main winding, is calculated, in particular based on the stator voltage signal.

Then, in sub-step S7.3, a relative rotor angle change is calculated based on the phase of the engine speed signal calculated in sub-step S7.1 and the relative phase change of the voltage of the stator 28 calculated in sub-step S7.2. Such relative phase change may be calculated using Clarke transformation, based e.g. on three alternating phases of the measurement signal that correspond to the respective main windings.

The determined phase of the engine speed signal and the relative phase change of the voltage of the stator 28 may be provided for the same time period or time point. In this way, the calculated phases may be essentially simultaneously obtained and the relative rotor angle is determined with a predefined temporal resolution, e.g. between one millisecond and one second, preferably between 10 milliseconds and 50 milliseconds.

In a next sub-step S7.4, the relative rotor angle change is compared to a predetermined relative rotor angle threshold. Specifically, in this step, it is determined whether the relative rotor angle change determined in step S7.3 exceeds the relative rotor angle threshold. More specifically, if the relative rotor angle change exceeds the threshold, an onset of pole slip is detected in step S8 and the method proceeds to step S9. By doing so, it is enabled that sudden relative rotor angle change, i.e. corresponding to a large rate of change, can be detected as an early indicator for the development or occurrence of a pole slip.

When onset of pole slip is detected, the control unit 30 is configured to initiate a pole slip protection mechanism in step S9 so as to avoid or reduce corresponding damages. For example, in step S9, in response to detecting onset of pole slip, the control unit 30 may be configured to output a signal, e.g., to a safety chain protector of a main controller. Such safety chain protector may, e.g., in response to receiving such a warning signal, effect actuation of the electrical connecting device 14 so as to disconnect, in particularly temporarily disconnect the generator 16 from the power grind 12. Alternatively, the control unit 30 may be configured to, in response to detecting onset of pole slip, effect actuation of the electrical connecting device 14 so as to disconnect, in particularly temporarily disconnect, the generator 16 from the power grind 12.

It will be obvious for a person skilled in the art that these embodiments and items only depict examples of a plurality of possibilities. Hence, the embodiments shown here should not be understood to form a limitation of these features and configurations. Any possible combination and configuration of the described features can be chosen according to the scope of the invention. This is in particular the case with respect to the following optional features which may be combined with some or all embodiments, items and/or features mentioned before in any technically feasible combination.

A method may be provided for detecting an onset of pole slip in an electric generator, in particular synchronous electric generator, driven by an engine, in particular by an internal combustion engine via a coupler, in particular a relatively stiff coupler, comprising a step of obtaining a stator voltage signal being indicative of a voltage in a stator of the generator; a step obtaining an engine speed signal being indicative of an engine speed of the engine; and a step of detecting an onset of pole slip based on the stator voltage signal and the engine speed signal. The method may be intended and configured for protecting the synchronous electric generator from pole slip.

With the proposed method, the stator voltage signal and the engine speed signal, which are required and used for detecting pole slip onset, may be obtained using sensory equipment, known generator set configurations are usually already equipped with. The proposed method therefore does not require any sensors which are additionally needed. Therefore, the proposed method may be easily implemented and employed, in particular in known generator set configurations. Furthermore, influence of the relatively stiff coupler may be considered to compensate angle changes induced by the inertia of the coupler. The coupler angle change is an add-on to the above mentioned angle when the generator is in both a steady state operation and in dynamic reactions.

The stator voltage signal may be indicative of a voltage in at least one main winding of the stator. Alternatively or additionally, in the step of obtaining a stator voltage signal, a voltage measurement from at least one main winding of the stator may be obtained.

The method may further comprising a step of determining an operating mode of the generator set, wherein in particular detection of the onset of pole slip is performed in dependence on the determined operating mode. Optionally, in the step of determining the operating mode, it may be determined whether or not the generator set is being operated in a steady state operating mode. Alternatively or additionally, in the step of determining the operating mode, the operating mode may be determined based on at least one of a rate of change of a load of the generator set and a rate of change of a rotational speed of the engine and/or a rate of change of rotation speed of an electrical magnetic field from stator.

Optionally, if it is determined that the generator set is being operated in the steady state operating mode, a further step of detecting the onset of pole slip is performed based on the stator voltage signal, and wherein if it is determined that the generator set is not in the steady state operating mode, e.g. is in a dynamic state, the step of detecting the onset of pole slip may be performed.

Optionally, the further step of detecting the onset of pole slip, the onset of pole slip is determined based on an absolute rotor angle level.

Alternatively or additionally, wherein in the step of detecting the onset of pole slip, the onset of pole slip may be detected based on a relative rotor angle change. Optionally, the relative rotor angle change is determined based on the stator voltage signal and the engine speed signal. Alternatively or additionally, the onset of pole slip may be detected based on a comparison of the relative rotor angle change to a relative rotor angle threshold.

In a further development, the method may comprise a further step of initiating a pole slip protection mechanism when the onset of pole slip is detected.

Furthermore, a control unit for detecting an onset of pole slip in a synchronous electric generator driven by an engine via a coupler may be provided. The control unit may be configured to perform the above described method. Further, the control unit may be configured for obtaining a stator voltage signal being indicative of a voltage in a stator of the generator; obtaining an engine speed signal being indicative of an engine speed of the engine; and detecting an onset of pole slip based on the stator voltage signal and the engine speed signal.

Furthermore, a generator set may be provided comprising an electrical generator driven by an internal combustion engine and the above described control unit for detecting an onset of pole slip in the electrical generator.

### Industrial Applicability

With reference to the Figures, a method and control unit for detecting an onset of pole slip in the electrical generator are suggested. The suggested method and control unit as mentioned above are applicable in any suitable generator set, which may replace conventional methods and control units for detecting pole slip.

### List of reference numerals

- 10: generator set
- 12: power grid
- 14: electrical connecting device
- 16: generator
- 18: engine
- 20: coupler
- 22: output shaft
- 24: input shaft
- 26: rotor
- 28: stator
- 30: control unit
- 30a: CPU
- 30b: memory
- 32: data interface
- 34: rotary speed sensor

## Claims

1. Method for detecting an onset of pole slip in a synchronous electric generator (16) driven by an engine (18) via a coupler (20), comprising:
a step (S 1) of obtaining a stator voltage signal being indicative of a voltage in a stator (28) of the generator (16);
a step (S3) obtaining an engine speed signal being indicative of an engine speed of the engine (18); and
a step (S7) of detecting an onset of pole slip based on the stator voltage signal and the engine speed signal.

2. Method according to claim 1, wherein the stator voltage signal is indicative of a voltage in at least one main winding of the stator (28).

3. Method according to claim 1 or 2, wherein in the step (S1) of obtaining a stator voltage signal, a voltage measurement from at least one main winding of the stator (28) is obtained.

4. Method according to any one of claims 1 to 3, further comprising a step (S5) of determining an operating mode of the generator set (10), wherein detection of the onset of pole slip is performed in dependence on the determined operating mode.

5. Method according to claim 4, wherein in the step (S5) of determining the operating mode, it is determined whether or not the generator set (10) is being operated in a steady state operating mode.

6. Method according to claim 4 or 5, wherein in the step (S5) of determining the operating mode, the operating mode is determined based on at least one of a rate of change of a load of the generator set (10) and a rate of change of a rotational speed of the engine (18) or of a rotor (26) of the generator (16).

7. Method according to claim 5 or 6, wherein if it is determined that the generator set (10) is being operated in the steady state operating mode, a further step (S6) of detecting the onset of pole slip is performed based on the stator voltage signal, and wherein if it is determined that the generator set (10) is not in the steady state operating mode, the step (S7) of detecting the onset of pole slip is performed.

8. Method according to claim 7, wherein in the further step (S6) of detecting the onset of pole slip, the onset of pole slip is determined based on an absolute rotor angle level.

9. Method according to any one of claims 1 to 8, wherein in the step (S7) of detecting the onset of pole slip, the onset of pole slip is detected based on a relative rotor angle change.

10. Method according to claim 9, wherein the relative rotor angle change is determined based on the stator voltage signal and the engine speed signal.

11. Method according to clam 9 or 10, wherein the onset of pole slip is detected based on a comparison (S7.4) of the relative rotor angle change to a relative rotor angle threshold.

12. Method according to any one of claims 1 to 11, further comprising a step (S9) of initiating a pole slip protection mechanism when the onset of pole slip is detected.

13. Control unit (30) for detecting an onset of pole slip in a synchronous electric generator (16) driven by an engine (18) via a coupler (20), wherein the control unit is configured for:
- obtaining a stator voltage signal being indicative of a voltage in a stator (28) of the generator (16);
- obtaining an engine speed signal being indicative of an engine speed of the engine (18); and
- detecting an onset of pole slip based on the stator voltage signal and the engine speed signal.

14. Generator set (10) comprising an electrical generator (16) driven by an internal combustion engine (18) and a control unit (30) according to claim 14 for detecting an onset of pole slip in the electrical generator (16).
